Europäisches Patentamt

European Patent Office

Office européen des brevets

(11) Publication number: **0 151 336**
**B1**

(12) **EUROPEAN PATENT SPECIFICATION**

(45) Date of publication of patent specification: **02.01.91**

(21) Application number: **84306602.8**

(22) Date of filing: **28.09.84**

(51) Int. Cl.⁵: **H 05 K 13/00, H 01 L 21/00**

(54) System for integrated circuit processing.

(30) Priority: **28.09.83 US 536600**
**29.03.84 US 594498**

(43) Date of publication of application:
**14.08.85 Bulletin 85/33**

(45) Publication of the grant of the patent:
**02.01.91 Bulletin 91/01**

(84) Designated Contracting States:
**DE FR GB**

(56) References cited:
**EP-A-0 009 424**
**WO-A-86/00870**
**US-A-4 208 159**
**US-A-4 412 771**

**SOLID STATE TECHNOLOGY, no. 7, July 1984,
pages 111-115, Washington, US; M. PARIKH et
al.: "A technology for wafer cassette transfer in
VLSI manufacturing"**

(73) Proprietor: **Hewlett-Packard Company
Mail Stop 20 B-O, 3000 Hanover Street
Palo Alto, California 94304 (US)**

(72) Inventor: **Parikh, Mihir
7174 Wooded Lake Drive
San Jose California 95120 (US)**
Inventor: **Tullis, Barclay J.
1795 Guinda Street
Palo Alto California 94303 (US)**
Inventor: **Thrasher, David Lawrence
430 O'Connor
Menlo Park California 94304 (US)**
Inventor: **Johnston, Mark E.
14221 Paul Avenue
Saratoga California 95070 (US)**

(74) Representative: **Liesegang, Roland, Dr. et al
FORRESTER & BOEHMERT Widenmayerstrasse
4
D-8000 München 22 (DE)**

Courier Press, Leamington Spa, England.

## Description

This invention is concerned with a system for integrated circuit processing.

Processing yield has long been a major concern in integrated circuit (IC) manufacturing. A major cause of IC processing failures is the existence of particles such as dust in the processing environment. Conventional IC processing is therefore done in a clean room in which the air is continuously circulated and filtered in an attempt to remove the airborne particles. In addition, personnel are usually clothed in special suits in an attempt to reduce the number of particles introduced as the workers move about the clean room. As a final step, many of the most vulnerable IC process steps are further contained beneath laminar flow down-drafts of filtered air to provide added protection from local sources of particulate contamination.

Unfortunately such an environment suffers from several disadvantages. Firstly, such specially designed rooms are not only fairly expensive to construct and maintain, but also working in such an environment is inconvenient. Secondly, since the size of particles which will cause product failure is usually equal to or greater than 1/4 to 1/3 the minimum feature size of the product, it is necessary to continually reduce contamination levels as dimensions are reduced in newer IC products in order to maintain acceptable process yields. This problem becomes especially acute as the minimum feature size drops below one micron for very large scale integrated (VLSI) ICs.

The present invention provides an interface between first and second containers characterised by alignment means for orienting the first container in a fixed position relative to the second container, first closure means for independently sealing the first container, second closure means for independently sealing the second container, each closure means being arranged to mate with the other so that substantially all contamination accumulating on exterior surfaces of the closure means when the containers are separated will be trapped therebetween when the containers are positioned together by said alignment means, and means for moving the closure means while mating together into one of the containers as a single unit.

An interface as set forth in the last preceding paragraph may be further characterized in that mating surfaces of the closure means contact substantially only in a region within a limited distance around the entire outer perimeters of said doors, so that the surface area of contact is small relative to the total surface areas of the closure means.

An interface as set forth in the last preceding paragraph may be further characterized in that the surface area of contact is less than 20% of the total surface areas of the closure means.

An interface as set forth in any one of the last three immediately preceding paragraphs may be further characterized in that said closure means comprise first and second doors arranged to be held together by gravity while the interface is being transported.

An interface as set forth in the last preceding paragraph may be further characterized by a gutter around the lower perimeter of the lower of the first and second doors.

An interface as set forth in any one of the last five immediately preceding paragraphs may be further characterized by latching means coupled to said closure means for holding said closure means together while said interface is being transported.

An interface as set forth in any one of the last six immediately preceding paragraphs may be further characterized by interlock means coupled to the first and second closure means for inhibiting the opening of the first closure means except when the first and second containers are mated in the alignment means.

An interface as set forth in the last preceding paragraph may be further characterized in that said interlock means comprises port latch means coupled to the first container for maintaining the first closure means in a closed position when the port latch means is in a closed position and for permitting the first closure means to open when the port latch means is in an opened position, pull means coupled to the first container for transporting the port latch means from the opened position to the closed position of the port latch means, said pull means being adapted so as not to independently transport the port latch means from the closed position to the opened position of the port latch means, and latch foot means coupled to the second container for engaging the port latch means and pull means so that together the pull means and the latch foot means can transport the port latch means from the closed position to the opened position of the port latch means.

An interface as set forth in the last preceding paragraph may be further characterized in that said port latch means further comprises a first spring to maintain the port latch means in the closed position when the first and second containers are not mated in the alignment means, independently of the position of the pull means.

An interface as set forth in either one of the last two immediately preceding paragraphs may be further characterized in that the latch foot means is further adapted for maintaining the second closure means in a closed position when the latch foot means is in a closed position and for permitting the second closure means to open when the latch foot means is in an opened position.

An interface as set forth in the last preceding paragraph may be further characterized in that the latch foot means further comprises a second spring to maintain the latch foot means in the closed position when the first and second containers are not mated in the alignment means.

An interface as set forth in any one of the last six immediately preceding paragraphs may be further characterized in that the latch foot means is further adapted to engage the alignment means when the port latch means is transported from the closed position to the ground position by the joint action of the latch foot means and the pull means, so that the first and second containers cannot be separated when the port latch means is in the opened position.

An interface as set forth in any one of the last five immediately preceding paragraphs may be further characterized in that the pull means further comprises movement means for transporting the pull means between first and second positions corresponding to the closed and opened positions respectively of the port latch means.

An interface as set forth in the last preceding paragraph may be further characterized in that the movement means comprises a double-acting pneumatic cylinder.

An interface as set forth in either one of the last two immediately preceding paragraphs may be further characterized in that the movement means comprises a pneumatic cylinder having a third spring to maintain the pull means in the first (closed) position when the pneumatic cylinder is not energized.

The present invention is a departure from the use of a conventional clean room in the fabrication of ICs. Instead, a novel standardized mechanical interface (SMIF) system is utilized that reduces particle contamination by significantly reducing particle fluxes onto wafers. This is done by mechanically assuring that during transportation, storage, and most processing steps, the gaseous media surrounding the wafers is essentially stationary relative to the wafers, and that particles from exterior "ambient" environments cannot enter the wafer environments. Experiments have shown that the SMIF system of wafer handling reduces wafer particle contamination by as much as ten times when compared to conventional Class 100 clean room wafer handling practice. In addition, since the level of SMIF system particle contamination is independent of the ambient external environment, IC manufacturing can proceed in a nonclean facility. Thus, not only is the expense and inconvenience of a clean room eliminated, but also process yields can be maintained or even improved for high density VLSI processes due to the lower concentration of particle contamination.

Experiments have shown that a significant number of processing defects in VLSI circuits are caused by particles and that many of these particles are related to material handling by humans even if low-particle clothing is employed. A sitting person with light hand, forearm and head movements even with proper clean-room clothing will emit more than 100,000 particles/minute, all larger than 0.3 microns. The SMIF system therefore consists of two parts: (1) a clean gas filled canopy around the wafer handling apparatus of each piece of processing equipment; and (2) a small, clean, still-gas box to carry wafers from machine to machine. The various pieces of the system are mechanically interfaced without the need of an air-lock by means of unique particle-free dockable doors which consist of a door on each piece of equipment that fit together to trap particles which have accumulated from the dirty ambient environment on the outer surfaces of the doors. Once linked together, the doors are moved as a unit into the clean interior space, thus opening a particle-free interface between the system components. Wafers are then moved through the system by mechanical arms and elevators without human intrusion. The actual wafer movement can also be fully automated through the use of robotic material handlers to further increase productivity. Thus by eliminating human handling of IC wafers and maintaining the wafers in a still-air environment throughout the majority of the IC process, particles are reduced and process yield is increased.

There now follows a detailed description which is to be read with reference to the accompanying drawings of an interface according to the present invention; it is to be clearly understood that this system has been selected for description to illustrate the invention by way of example and not by way of limitation.

In the accompanying drawings:-

Figure 1 shows a first SMIF subsystem component, a canopy, according to a preferred embodiment of the present invention;

Figures 2A and 2B show a second SMIF subsystem component, a cassette port, according to a preferred embodiment of the present invention;

Figures 3A, 3B and 3C show three versions of a third SMIF subsystem component, a cassette manipulator, according to a preferred embodiment of the present invention;

Figure 4A shows the canopy interfaced to the cassette port according to a first embodiment of the present invention;

Figure 4B shows the canopy interfaced to the cassette port according to a second embodiment of the present invention;

Figure 5 shows an alternative embodiment of an interface as shown in Figure 4;

Figure 6 shows a SMIF box storage unit according to a preferred embodiment of the present invention;

Figures 7A-7C, 8A-8C, 9A-9B, 10A-10C, 11, 12A-12C, 13A-13C, 14A-14C, and 15A-15C show the subassemblies for the embodiment of the present invention according to Figure 6;

Figure 16 shows a SMIF box storage unit according to a preferred embodiment of the present invention;

Figure 17 shows a cassette storage unit according to a preferred embodiment of the present invention; and

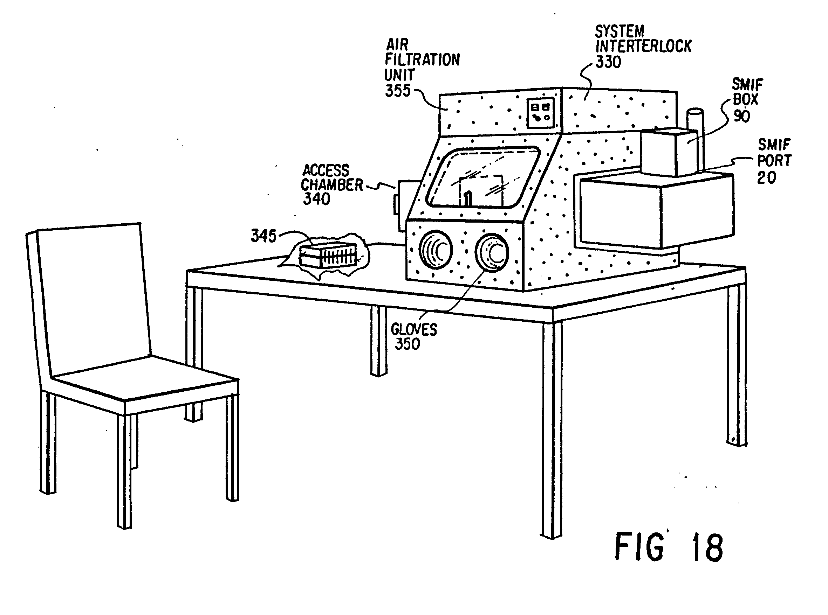

Figure 18 shows a system interlock according to a preferred embodiment of the present invention.

Conceptually, the SMIF system has two parts:

1) a clean air canopy around the wafer handling apparatus of each piece of processing equipment; and

2) a small clean air box to carry wafers from machine to machine.

In practice, the SMIF system is built from several of the small clean air boxes and canopies to form SMIF subsystems, each of which are built from three SMIF subsystem components.

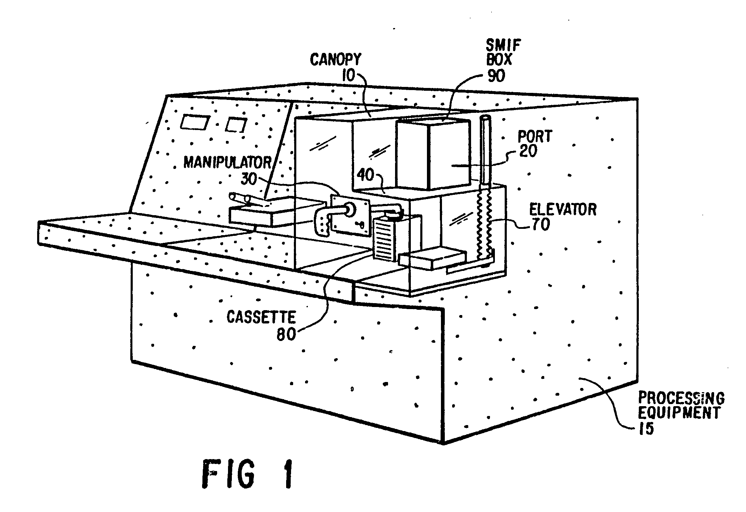

The first SMIF subsystem component as shown in Figure 1 is first enclosure means in the form of the canopy 10. The canopy 10 is an easily removable shield that covers the wafer handling mechanisms of each piece of processing equipment 15 (e.g., photoresist applicators, mask aligners, inspection equipment, etc.). Generally, the canopy 10 is constructed of transparent plastics material such as Lexan to facilitate inspection and/or maintenance within the canopy 10 which may later become necessary. The other subsystem components are a SMIF cassette port 20 and a SMIF cassette manipulator 30 which are bolted onto the canopy 10 in locations that allow easy movement within the canopy 10. Because the canopy 10 encloses the handling mechanisms of the processing equipment 15, there is no need to enclose the processing equipment 15 within a clean room.

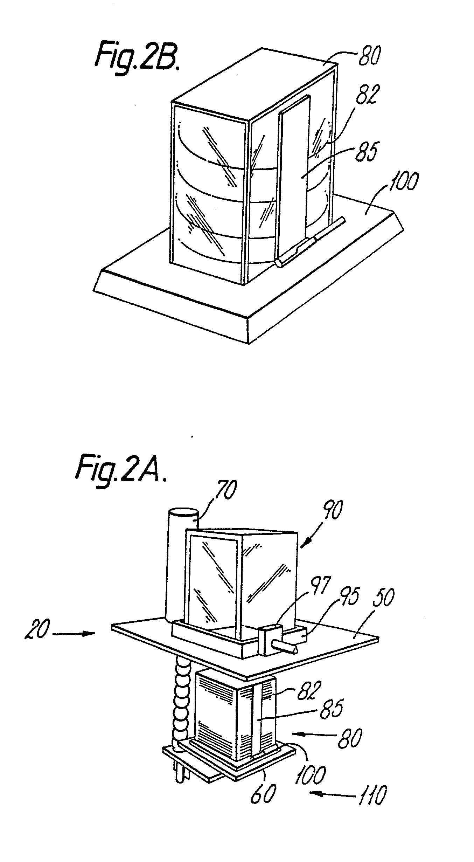

Figure 2A shows the details of the SMIF cassette port 20. The port 20 is typically mounted on a horizontal surface 40 of the canopy 10 by means of a canopy mounting plate 50. The port 20 further consists of a first closure means provided by a port door 60 and an elevator mechanism 70 that transports a cassette 80 containing IC wafers 82 into the interior of the canopy 10. The wafers 82 are held in the cassette 80 by a wafer dampener 85 as shown in Figure 2B which is mounted on a door 100 and is activated by the weight of the cassette 80.

A SMIF box 90, which is used for transporting cassettes 80 from one piece of processing equipment 15 to another, interfaces with the canopy 10 via the SMIF port 20. The SMIF box 90 is aligned with the SMIF port 20 by means of a wedge shaped lip 95 and has a door 100 which interlocks with the door 60 on the port 20. An interlocking latch mechanism 97 is provided so that doors 60 and 100 can only be opened when the SMIF box 90 is positioned in the alignment lip 95. Doors 60 and 100 together provide a particle-free dockable interface 110, shown in Figure 2A in the open position, which will be described in detail below. The interface 110 also provides means for latching the box 90 to the port 20 so that the elevator mechanism 70 can freely transport the cassette 80 between the box 90 and the canopy 10. The doors 60 and 100 are designed so that the majority of particles on the exterior surfaces of the doors 60 and 100 are trapped between the doors 60 and 100. Thus, the wafers carried in the cassette 80 are not contaminated when the interface 110 is opened.

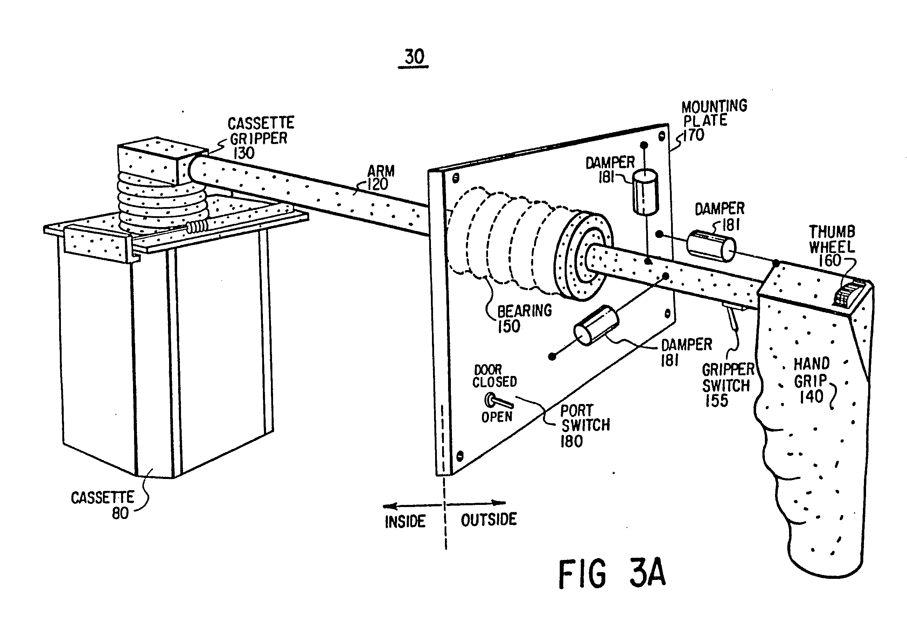

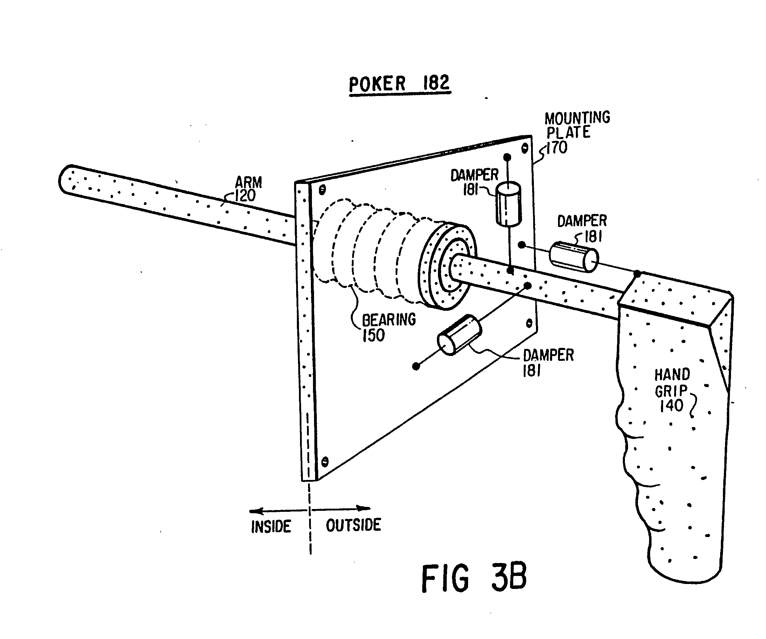

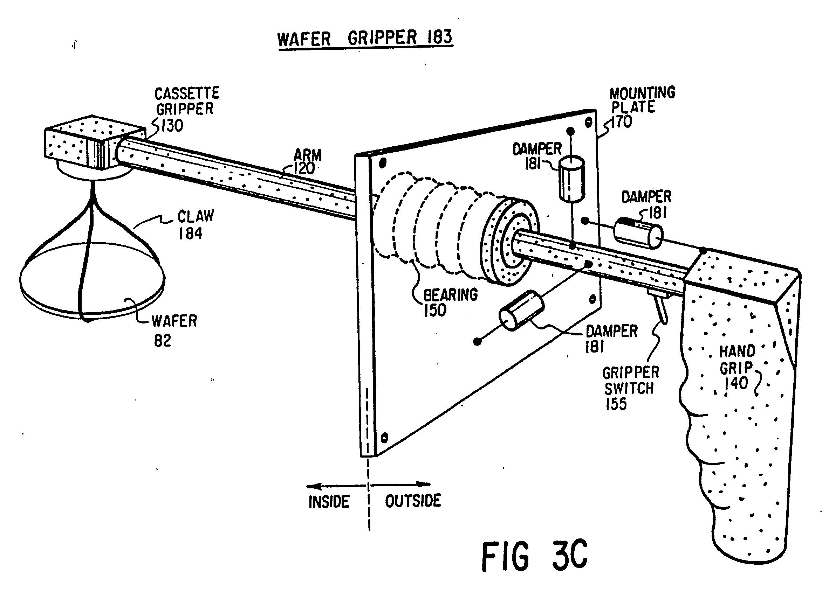

Once the cassette 80 is within the canopy 10, the cassette 80 can be manouevered as needed by the cassette manipulator 30. A manually operable cassette manipulator 30 is shown in Figure 3A. The manipulator 30 typically has an arm 120 which is 60-90 cms. long and extends through an opening in a front wall of the canopy 10. The arm 120 has a cassette gripper 130 mounted on its inside (clean air) end portion and a hand grip 140 on its outside (ambient) end portion. A bearing 150 provides angular and in-out movement for the arm 120 as well as providing an air seal to prevent the intrusion of dirty ambient air. The cassette gripper 130 is actuated by a gripper switch 155 to hold the cassette 80 which can then be rotated about the vertical axis by a thumb wheel 160 mounted on the hand grip 140 and coupled to the cassette gripper 130. A manipulator mounting plate 170 supports the bearing 150 and a port actuation switch 180 which actuates both the latching of doors 60 and 100 and the movement of the elevator mechanism 70. Mechanical dampers 181 are provided along the three axes of motion of the arm 120 to limit the speed of movement of the gripper 130. The manipulator mounting plate 170 is bolted to the canopy 10 as shown in Figure 1. Two alternatives of the cassette manipulator 30 which are often useful are a poker 182 as shown in Figure 3B and a wafer gripper 183 as shown in Figure 3C. The poker 182 is a cassette manipulator 30 without a gripper 130 and is used to push objects within the canopy 10. The wafer gripper 183 is a cassette manipulator 30 with a three-pronged claw 184 or similar mechanism replacing the cassette gripper 130 so that the wafers can be grasped directly as needed. An alternative manipulator may be provided by an air-tight glove.

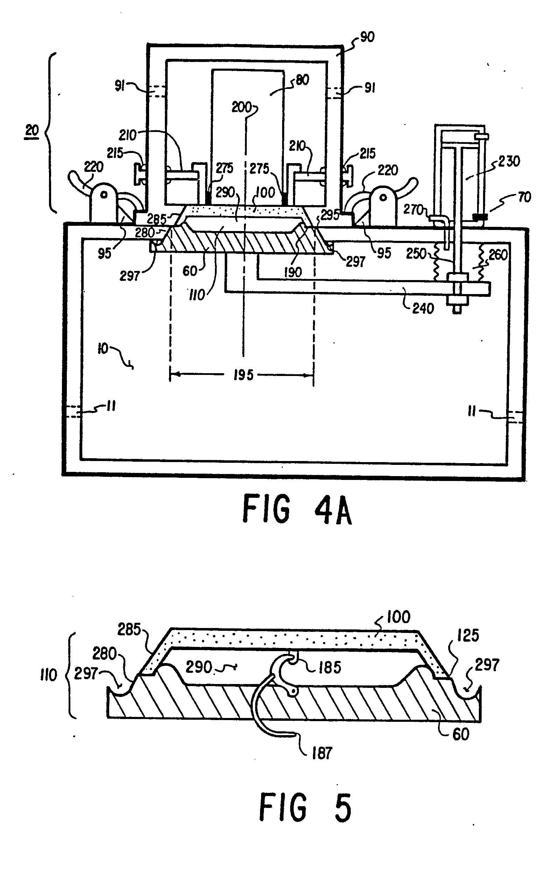

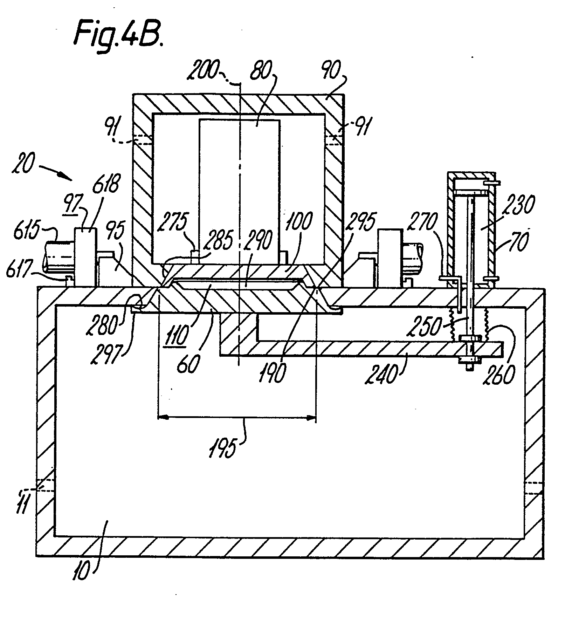

It should be noted that both the canopy 10 and SMIF box 90 described above totally exclude humans and do not utilize constantly moving filtered air to decrease particles on the IC wafer surfaces. Rather, IC cleanliness is achieved by maintaining a still-air interior environment. The canopy 10 and box 90 can each be equipped with particle-filtered openings 11 and 91 respectively, (see Figures 4A and 4B) to allow continuous equalization between internal and external (ambient) air pressures. Such filtered pressure equalization openings 11 and 91 minimize pressure difference and air flow between the canopy 10 and box 90 as the interface 110 is opened and the wafers are moved from the box 90 into the canopy 10. In addition, access to the interiors of the canopy 10 and box 90 is by means of mechanical arms which occupy essentially constant volume within the enclosures so that there is no significant change in interior volume as IC wafers are moved about. Hence, since there is little or no change of interior air pressure during processing, there is no need for air-tight seals on the canopy 10 or box 90, and particles on the IC wafer surfaces are further decreased by inhibiting the movement of air.

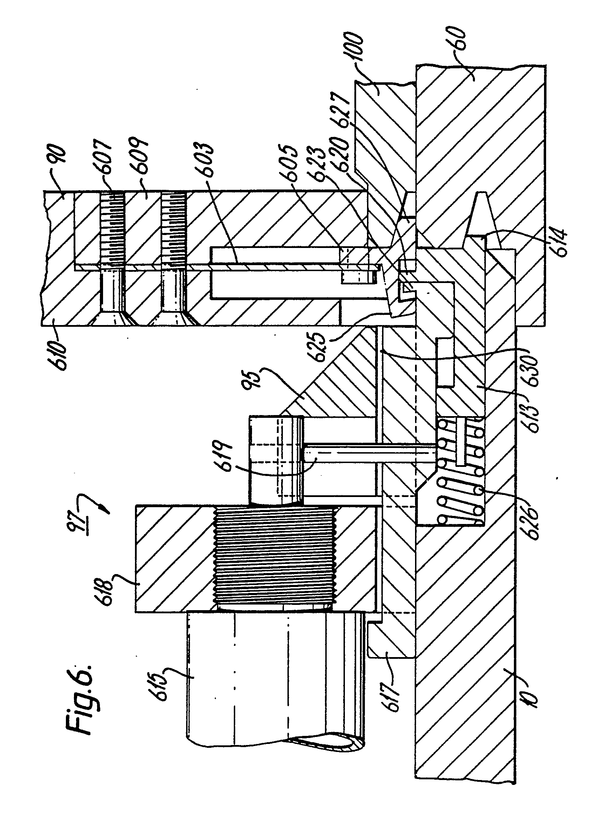

Figures 4A and 4B show vertically openable versions of the SMIF cassette port 20. A horizontally openable version is also easily achieved by slight mechanical modifications to the vertically openable version to include a positive spring loaded latch 185 and release cable 187 as shown in Figure 5 between the doors 60 and 100 since gravity cannot be used to hold the doors together. The cassette box 90 is designed to contain one cassette 80 and is only slightly larger than the cassette 80 itself, which holds the IC wafers. The cassette box 90 will generally have transparent walls to facilitate observations by humans which may be necessary. The particle-free dockable interface 110 mentioned earlier permits clean, particle-free access between two otherwise independent clean environmental systems such as the canopy 10 and the SMIF box 90. The interface 110 avoids letting air-borne particles, especially those in the size range between 0.1 to 20 microns, from entering the otherwise clean equipment containers.

Figures 4A and 4B show the interconnection of the envelopes of the closed spaces defined by the canopy 10 and the cassette box 90 along a contact area 190. In the present invention it is necessary to open the contact area 190 without exposing these spaces to the external environment or to the previously external surfaces of the doors 60 and 100 to these spaces. In particular, when the doors 60 and 100 are opened, the portions of the external surfaces of the contact area 190 lying within the contact opening 195 are made to contact one another thereby trapping particles which may exit on the external surfaces between the doors 60 and 100. The contact area 190 is then kept in contact while the doors 60 and 100 are moved as a single unit into the space defined by the canopy 10. The doors 60 and 100 are either circularly or rectangularly symmetrical about an axis 200.

In the embodiment of Figure 4A, before the interface 110 is opened, the door 100 is held in place by latches 210 which pass through the walls of the box 90 by means of airtight bearings or bushings 215. The spaces 10 and 90 are held together in lip 95 by clamp 220.

Before the interface 110 is opened, the SMIF box 90 is aligned in lip 95 on the canopy 10 as shown in Figure 4B to prevent the intrusion of dirty ambient air.

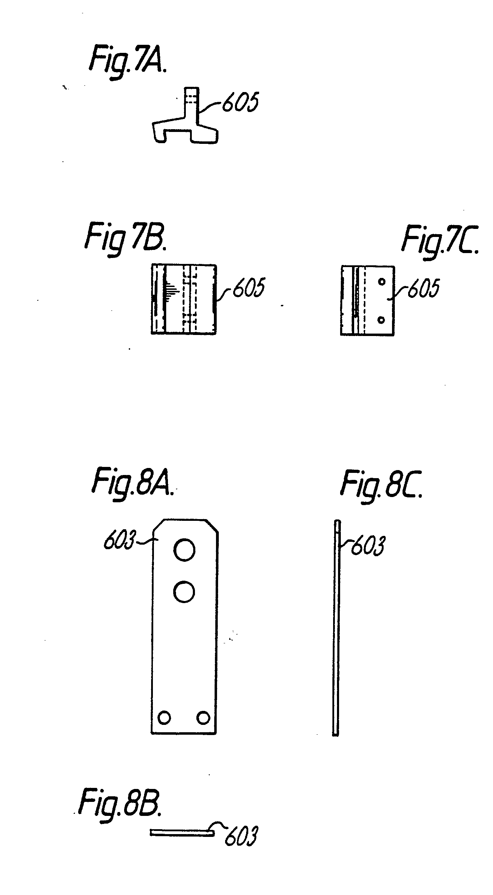

Figure 6 shows a cross-sectional view of the details of the interlocking latch mechanism 97 employed in the embodiment of Figure 4B, which prevents the opening of the door 60 at inappropriate times. A latch spring 603 and latch foot 605 are attached by screws 607 to a latch nut 609 within a side wall 610 of the SMIF box 90. The first purpose of the latch foot 605 is to retain the door 100 which forms the bottom of the SMIF box 90 via the force of the latch spring 603. The door 60 of the canopy 10 is held in place to the canopy 10 by a port latch 613 having a protrusion 614 which fits into the door 60. A pneumatic latch cylinder 615 mounted on a support 618 is coupled to a door pull 617 by a dowel 619, and the entire door pull assembly 615, 617, 618 and 619 is mounted on the canopy 10 above the port latch 613. The latch cylinder 615 can be either a double acting pneumatic cylinder in which a pressure must be applied to open or close the door pull 617, or a single acting pneumatic cylinder with a spring return which acts to keep the door pull 617 closed as shown to the right. Mounting of the SMIF box 90 to the canopy 10 is accomplished by placing the SMIF box 90 such that it is lined up within the alignment lip 95, and the latch foot 605 lies immediately above protrusions 620 and 623 which are parts of the port latch 613 and the door pull 617, respectively. A pneumatic control signal to open the doors 60 and 100 causes the latch cylinder 615 to pull the door pull 617 to the left as shown away from the door 60. If a SMIF box 90 is not in place when the door pull 617 moves, a spring 626 prevents the port latch 613 from moving and the door 60 will remain closed and latched, thus protecting the clean air space within the canopy 10 from intrusion of dirty ambient air. If a SMIF box 90 is in place as shown in Figure 6, the door pull 617 pulls the protrusions 625 and 627 of the latch foot 605 to release the door 100. At the same time the protrusion 620 of the port latch 613 is pulled via protrusion 627 to disengage protrusion 614 from the door 60. The pair of doors 60 and 100 can then be opened as a unit. In addition, when the doors 60 and 100 have been released, the latch foot 605 engages an inside slot 630 in the alignment lip 95 to prevent the SMIF box 90 from being lifted from the canopy 10.

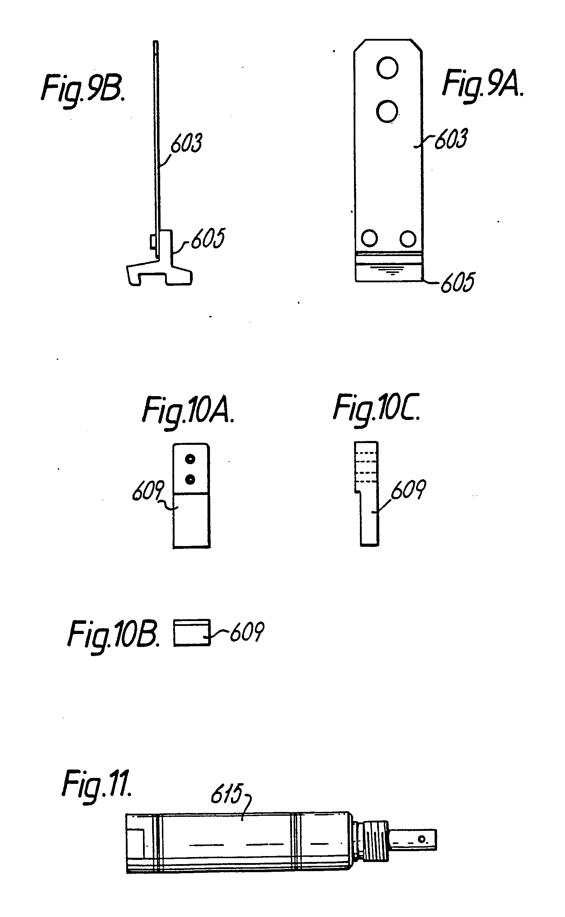

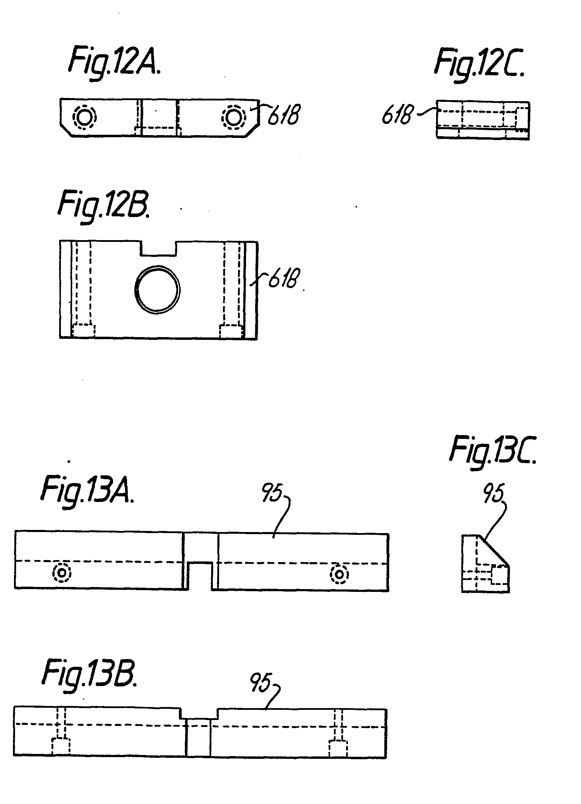

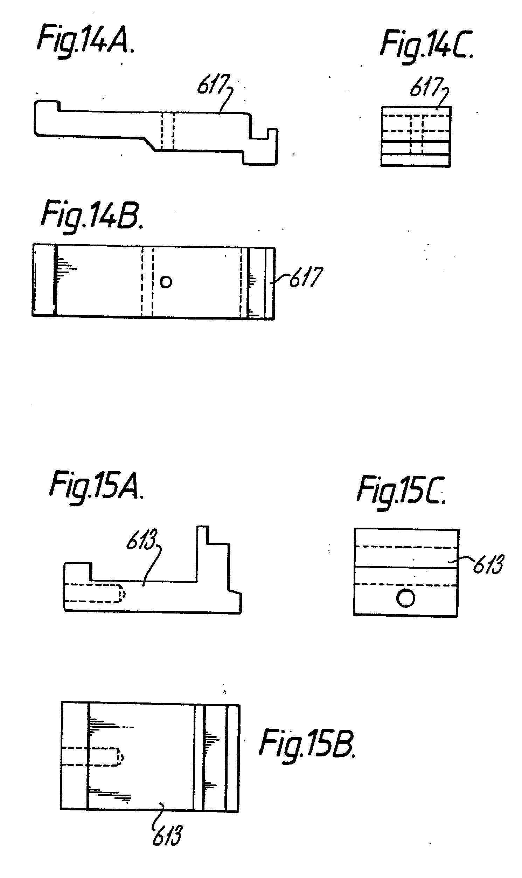

The details of the latch foot 605 are shown in Figures 7A-7C, the latch spring 603 is shown in Figures 8A-8C, and an assembled latch spring 603 and latch foot 605 is shown in Figures 9A and 9B. The details of the latch nut 609 are shown in Figures 10A-10C; the details of the latch cylinder 615 are shown in Figure 11; the details of the support 618 are shown in Figures 12A-12C; the details of the alignment lip 95 are shown in Figures 13A-13C; the details of the door pull 617 are shown in Figures 14A-14C; and the details of the port latch 613 are shown in Figures 15A-15C.

In both of the embodiments shown in Figures 4A and 4B, a piston 230 of the elevator mechanism 70 is located outside the canopy 10 and the box 90 to conserve space within the enclosures. The piston 230 is coupled to the door 60 by an arm 240 and a rod 250 secured thereto. The rod 250 passes through the wall of the canopy 10 and a bellows 260 around the lower portion of the rod prevents the intrusion of dirty ambient air. A vent 270 is provided to allow the equalization of air pressure inside the bellows 260 as the elevator 70 moves and the bellows 260 expands or contracts. Note that the air passing through the vent 270 is dirty ambient air, but this does not contaminate the interior of the canopy 10 because the bellows is sealed to the inside of the canopy 10 and to the arm 250. To open the interface 110, the latches are released, the piston 230 is extended, and the elevator 70 transports both doors 60 and 100 as a unit into the interior of the canopy 10, thereby carrying the cassette 80 aligned with the aid of guide lips 275 into the interior while trapping surface particles between the two doors 60 and 100 and preventing the intrusion of dirty ambient air.

In order to trap surface particles between the doors 60 and 100 it is only necessary that the doors contact each other uniformly and closely around their outer perimeters 280 and 285 respectively. The doors 60 and 100 need not fit flush with each other along the entire interface 110. In fact, it is desirable that an air gap 290 inside of the outer perimeters 280 and 285 be left between the doors 60 and 100. The air gap 290 provides a compressive air space between the doors 60 and 100 so that the dirty air trapped between the doors 60 and 100 does not rush out at high velocity in the plane perpendicular to axis 200 as the doors 60 and 100 are brought together, thereby potentially sweeping part of the dirty trapped air into the interior of the canopy 10 or the box 90. The air gap 290 also prevents doors 60 and 100 from becoming affixed together by air pressure as could occur if the contact area 190 was a large, closely fitting surface. Typically the air gap 290 will occupy more than 80% of the contact opening 195.

Ideally, the doors 60 and 100 should fit together so that perimeters 280 and 285 form one continuous surface. Therefore, joggle 295 where perimeters 280 and 285 meet should be kept as small as possible (e.g., less than .254 - .508 mm) since particles on the joggle 295 will be carried into the interiors of the canopy 10 and the box 90 when the interface 110 is opened. Some particles may be present on the perimeters 280 and 285 so a particle gutter 297 is provided on the door 60 to catch any particles which might roll down the perimeters 280 and 285 when the interface 110 is opened. Alternatively, the particle gutter 297 can be omitted to permit any particles from the perimeters 280 and 285 to settle all the way to the bottom of the canopy 10.

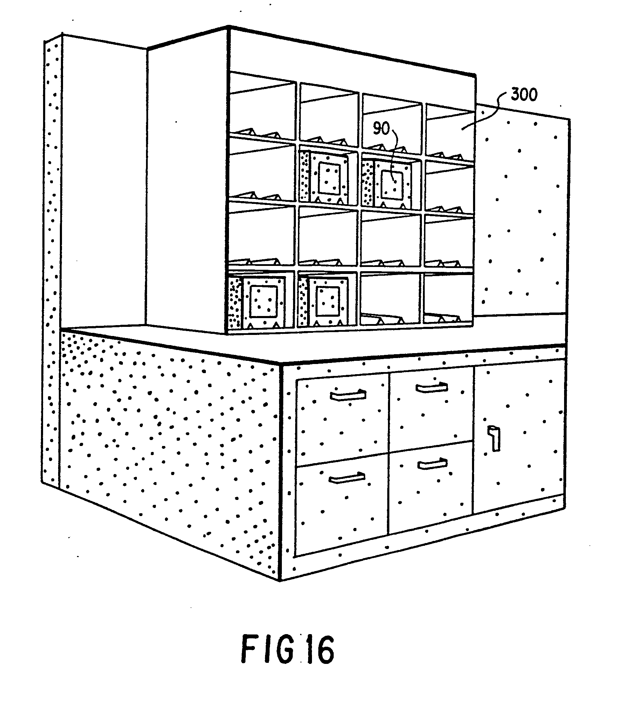

Figure 16 shows a SMIF box storage unit 300. The box storage unit 300 is basically an open rack for storing cassette boxes 90.

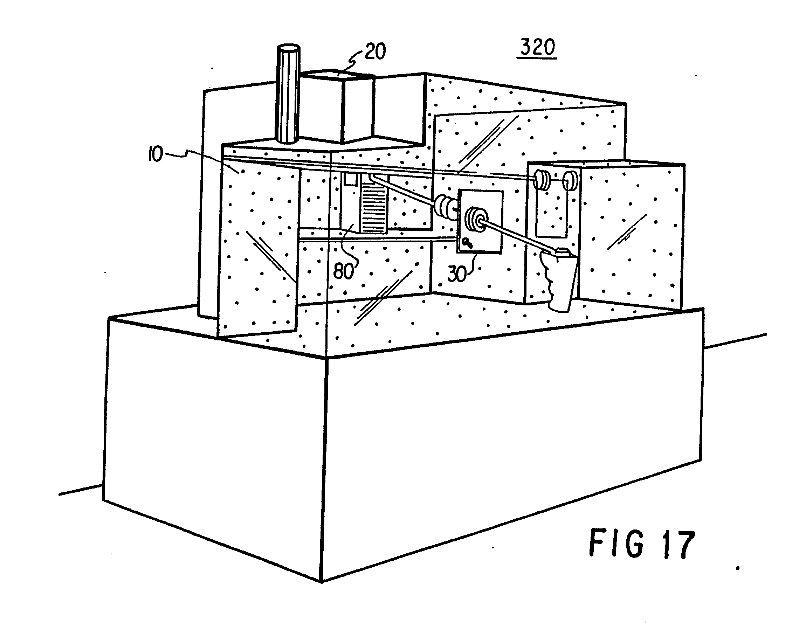

Figure 17 shows a cassette storage unit 320 for storing cassettes 80 holding IC wafers. The cassette storage unit 320 is a desiccator box with a canopy 10, port 20, and manipulator 30 added to it. The cassette storage unit 320 will typically function as a cassette processing buffer.

Initial cassette entry into the SMIF system occurs through the system interlock 330 as shown in Figure 8. This is typically a four-foot wide glove box defining a main chamber 335 with an access chamber 340 at one end and a SMIF port 20 at the other end. The complex movements required to transfer wafers from a new wafer package 345 into a cassette (not shown) necessitates the use of gloves 350 rather than mechanisms. Cassettes 80 and wafers enter and leave the SMIF system through the access chamber 340. Note that since the internal pressure of the system interlock 330 can change abruptly as human arms are thrust in and out of the gloves 350, it is necessary that the system interlock 330 be tightly constructed to prevent the intrusion of outside unfiltered air and it is also necessary to utilize an air filtration unit 355 on the system interlock 330. The air filtration unit 355 can contain both a conventional forced air filter and/or a particle collector such as an electrostatic precipitator. Although generally less desirable from a particle contamination standpoint than using mechanical manipulators 30 on the canopy 10 as shown in Figure 1, gloves 350 could be used to provide further flexibility of motion within canopy 10. Such gloves 350 are especially useful to provide maintenance within canopy 10 during periods when no IC wafers are present which can be contaminated by the intrusion of outside unfiltered air caused by use of the gloves 350. Filtration units 355 could also be used on the canopy 10 during such maintenance periods to remove any particles which may have intruded.

Because ICs are transported in their own closed containers and handling is done by mechanical arms it is also possible to fully automate the IC production facility by the use of stationary or mobile robots which use computer controlled robotic manipulators coupled to the SMIF components. Whether handling is done manually or automatically, by combining the SMIF components with conventional IC processing equipment the IC fabrication area can for the first time be constructed without the need of a conventional clean room environment, while at the same time improving IC cleanliness.

## Claims

1. An interface between first and second containers of a system for integrated circuit processing characterized by:

alignment means (95) for orienting the first container in a fixed position relative to the second container;

first closure means (100) for independently sealing the first container;

second closure means (60) for independently sealing the second container;

each closure means being arranged to mate with the other so that substantially all contamination accumulating on exterior surfaces of the closure means when the containers are separated will be trapped therebetween when the containers are positioned together by said alignment means; and

means (70) for moving the closure means while mating together into one of the containers as a single unit.

2. An interface according to claim 1 characterized in that mating surfaces of the closure means contact substantially only in a region within a limited distance around the entire outer perimeters of said doors, so that the surface area of contact is small relative to the total surface areas of the closure means.

3. An interface according to claim 2 characterized in that the surface area of contact is less than 20% of the total surface areas of the closure means.

4. An interface according to any one of the preceding claims characterized in that said closure means comprises first and second doors (100, 60) arranged to be held together by gravity while the interface is being transported.

5. An interface according to claim 4 and further characterized by a gutter (297) around the lower perimeter of the lower of the first and second doors.

6. An interface according to any one of the preceding claims and further characterized by latching means (185, 187) coupled to said closure means for holding said closure means together while said interface is being transported.

7. An interface according to any one of the preceding claims further characterized by interlock means (97) coupled to the first and second closure means (100, 60) for inhibiting the opening of the first closure means except when the first and second containers are mated in the alignment means.

8. An interface according to claim 9 characterized in that said interlock means comprises:

port latch means (613) coupled to the first container for maintaining the first closure means in a closed position when the port latch means is in a closed position and for permitting the first closure means to open when the port latch means is in a opened position;

pull means (617) coupled to the first container for transporting the port latch means from the opened position to the closed position of the port latch means, said pull means being adapted so as not to independently transport the port latch means from the closed position to the opened position of the port latch means; and

latch foot means (605) coupled to the second container for engaging the port latch means and pull means so that together the pull means and the latch foot means can transport the port latch means from the closed position to the opened position of the port latch means.

9. An interface according to claim 8 characterized in that said port latch means further comprises a first spring (626) to maintain the port latch means (613) in the closed position when the first and second containers are not mated in the alignment means, independently of the position of the pull means.

10. An interface according to either one of claims 8 and 9 characterized in that the latch foot means (605) is further adapted for maintaining the second closure means (60) in a closed position when the latch foot means is in a closed position and for permitting the second closure means to open when the latch foot means is in an opened position.

11. An interface according to claim 10 characterized in that the latch foot means further comprises a second spring (603) to maintain the latch foot means (605) in the closed position when the first and second containers are not mated in the alignment means.

12. An interface according to any one of the claims 8 to 11 characterized in that the latch foot (605) means is further adapted to engage the alignment means (95) when the port latch means (613) is transported from the closed position to the ground position by the joint action of the latch foot means and the pull means (617), so that the first and second containers cannot be separated when the port latch means is in the opened position.

13. An interface according to any one of claims 8 to 12 characterized in that the pull means (617) further comprises movement means (615, 619) for transporting the pull means between first and second positions corresponding to the closed and opened positions respectively of the port latch means (613).

14. An interface according to claim 13 characterized in that the movement means comprises a double-acting pneumatic cylinder (615).

15. An interface according to either one of claims 13 and 14 characterized in that the movement means comprises a pneumatic cylinder having a third spring to maintain the pull means (617) in the first (closed) position when the pneumatic cylinder is not energized.

**Patentansprüche**

1. Schnittstelle zwischen ersten und zweiten Behältern eines Systems zum Behandeln von integrierten Schaltungen, gekennzeichnet durch:

eine Ausrichtvorrichtung (95) zum Ausrichten des ersten Behälters in einer festen Position bezüglich des zweiten Behälters;

eine erste Schließvorrichtung (100) zum unabhängigen Abdichten des ersten Behälters;

eine zweite Schließvorrichtung (60) zum unabhängigen Abdichten des zweiten Behälters,

wobei die Schließvorrichtungen (60) zum passenden Anlegen aneinander derart angeordnet sind, daß praktisch alle Verunreinigungen, welche sich auf den Außenflächen der Schließvorrichtungen in deren getrenntem Zustand ansammeln, dazwischen eingefangen werden, wenn die Behälter mittels der Ausrichtvorrichtung in Position zusammengebracht sind, und

Mittel (70) zum Bewegen der Schließvorrichtungen in vereinigtem Zustand in einen der beiden Behälter als Einheit.

2. Schnittstelle nach Anspruch 1, dadurch gekennzeichnet, daß die aneinander anliegenden Flächen der Schließvorrichtungen im wesentlichen nur in einem Gebiet innerhalb einer begrenzten Distanz um ihre gesamten Außenumfänge herum Kontakt haben, so daß der Oberflächenkontaktbereich bezogen auf die Gesamtflächen der Schließvorrichtungen klein ist.

3. Schnittstelle nach Anspruch 2, dadurch gekennzeichnet, daß der Oberflächenkontaktbereich kleiner als 20% der gesamten Oberflächen der Schließvorrichtungen ist.

4. Schnittstelle nach einem der vorhergehenden Ansprüche, dadurch gekennzeichnet, daß die Schließvorrichtungen erste und zweite Türen (100, 60) umfassen, die durch Schwerkraft zusammengehalten sind, wenn die Schnittstelle transportiert wird.

5. Schnittstelle nach Anspruch 4 war gekennzeichnet durch eine den unteren Umfang der unteren Tür umgebende Nut (297).

6. Schnittstelle nach einem der vorangehenden Ansprüche, gekennzeichnet durch mit den Schließvorrichtungen gekuppelte Verriegelungsmittel (185, 187) zum Zusammenhalten der Schließvorrichtungen beim Transport der Schnittstelle.

7. Schnittstelle nach einem der vorangehenden Ansprüche, gekennzeichnet durch eine mit den ersten und zweiten Schließvorrichtungen (100, 60) verbundene Sperrvorrichtung (97) zum Verhindern des Öffnens der ersten Schließvorrichtung ausgenommen. daß die ersten und zweiten Behälter in der Ausrichtvorrichtung vereinigt sind.

8. Schnittstelle nach Anspruch 9, dadurch gekennzeichnet, daß die Sperrvorrichtung umfaßt:

einen Port-Riegel (613), der mit dem ersten Behälter gekuppelt ist. um die erste Schließvorrichtung in geschlossener Position zu halten. wenn der Port-Riegel in geschlossener Position ist, und um die erste Schließvorrichtung öffnen zu lassen, wenn der Port-Riegel in Öffnungsstellung ist;

eine mit dem ersten Behälter gekuppelte Zugvorrichtung (617) zum Bringen des Port-Riegels aus dessen Öffnungsstellung in seine Schließstellung, wobei die Zugvorrichtung so angeordnet und ausgebildet ist, daß sie den Port-Riegel nicht unabhängig aus dessen Schließstellung in seine Öffnungsstellung bringen kann, und

ein mit dem zweiten Behälter gekuppeltes Riegel-Fußteil (605) zum Zusammenwirken mit dem Port-Riegel und der Zugvorrichtung derart, daß diese zusammen mit dem Riegel-Fußteil den Port-Riegel aus dessen Schließstellung in seine Öffnungsstellung bringen kann.

9. Schnittstelle nach Anspruch 8, dadurch gekennzeichnet, daß der Port-Riegel ferner eine erste Feder (626) zum Halten des Port-Riegels (613) in Schließstellung aufweist, wenn die ersten und zweiten Behälter in der Ausrichtvorrichtung nicht vereinigt sind, und zwar unabhängig von der Position der Zugvorrichtung.

10. Schnittstelle nach Anspruch 8 oder 9, dadurch gekennzeichnet, daß das Riegel-Fußteil (605) ferner dazu ausgebildet ist, die zweite Schließvorrichtung (60) in Schließstellung zu halten, wenn das Riegel-Fußteil in Schließstellung ist, und ein Öffnen der zweiten Schließvorrichtung zuzulassen, wenn das Riegel-Fußteil in Öffnungsstellung ist.

11. Schnittstelle nach Anspruch 10, dadurch gekennzeichnet, daß das Riegel-Fußteil ferner eine zweite Feder (603) zum Halten des Riegel-Fußteiles (605) in Schließstellung aufweist, wenn die ersten und zweiten Behälter nicht in der Ausrichtvorrichtung vereinigt sind.

12. Schnittstelle nach einem der Ansprüche 8 bis 11, dadurch gekennzeichnet, daß das Riegel-Fußteil (605) ferner dazu ausgebildet ist, mit der Ausrichtvorrichtung (95) zusammenzuwirken, wenn der Port-Riegel (613) aus der Schließrichtung in die Grundstellung durch eine gemeinsame Aktion des Riegel-Fußteiles und der Zugvorrichtung (617) transportiert wird, so daß die ersten und zweiten Behälter nicht getrennt werden können, wenn der Port-Riegel in Öffnungsstellung ist.

13. Schnittstelle nach einem der Ansprüche 8 bis 12, dadurch gekennzeichnet, daß die Zugvorrichtung (617) ferner einen Antrieb (615, 619) zum Bewegen der Zugvorrichtung zwischen ersten und zweiten Positionen entsprechend jeweils der Schließstellung und der Öffnungsstellung des Port-Riegels umfaßt.

14. Schnittstelle nach Anspruch 13, dadurch gekennzeichnet, daß der Antrieb einen doppeltwirkenden pneumatischen Zylinder (615) aufweist.

15. Schnittstelle nach Anspruch 13 und 14, dadurch gekennzeichnet, daß der Antrieb einen pneumatischen Zylinder mit einer dritten Feder zum Halten der Zugvorrichtung (617) in der ersten (geschlossenen) Position aufweist, wenn der pneumatische Zylinder nicht aktiviert ist.

**Revendications**

1. Jonction entre un premier et un second contenant d'un système pour le traitement de circuits intégrés, caractérisée par:

un moyen d'alignement (95) pour orienter le premier contenant à une position fixe par rapport au second contenant;

un premier moyen de fermeture (100) pour fermer le premier contenant indépendamment;

un second moyen de fermeture (60) pour fermer le second contenant indépendamment;

chaque moyen de fermeture étant agencé pour être complémentaire à l'autre, de manière que pratiquement toutes les impuretés s'accumulant sur les surfaces externes des moyens de fermeture, lorsque les contenants sont séparés, soient piégés entre eux quand les contenants sont positionnés de façon qu'ils soient appliqués l'un contre l'autre par le moyen d'alignement; et

un moyen (70) pour déplacer les moyens de fermeture conjointement dans l'un des contenants lorsqu'ils sont disposés ensemble à complémentarité de formes.

2. Jonction selon la revendication 1, caractérisée en ce que les surfaces complémentaires des moyens de fermeture ne viennent pratiquement en contact l'une avec l'autre que dans une région s'étendant sur une distance limitée autour de la totalité des périmètres extérieurs des moyens de fermeture, de manière que l'aire de contact soit petite par rapport aux aires de surface totales des moyens de fermeture.

3. Jonction selon la revendication 2, caractérisée en ce que l'aire de contact est inférieure à 20% du total des aires de surface des moyens de fermeture.

4. Jonction selon l'une quelconque des revendications précédentes, caractérisée en ce que les moyens de fermeture sont constitués par une première et une seconde trappe (100, 60) agencées pour être maintenues ensemble par gravité pendant que la jonction est déplacée.

5. Jonction selon la revendication 4, caractérisée en ce qu'elle comporte en outre une gouttière (297) autour du périmètre inférieur de la trappe la plus basse des première et seconde trappes.

6. Jonction selon l'une quelconque des revendications précédentes, caractérisée en ce qu'elle comporte en outre des moyens de verrouillage (85, 87) couplés aux moyens de fermeture pour maintenir ces moyens de fermeture ensemble pendant que la jonction est déplacée.

7. Jonction selon l'une quelconque des revendications précédentes, caractérisée en ce qu'elle comporte en outre un moyen de blocage (97) accouplé aux premier et second moyens de fermeture (100, 60) pour empêcher l'ouverture du premier moyen de fermeture sauf lorsque les premier et second contenants sont disposés à complémentarité de formes dans le moyen d'alignement.

8. Jonction selon la revendication 7, caractérisée en ce que le moyen de blocage comprend:

un moyen de verrouillage d'accès (613), qui est accouplé au premier contenant pour maintenir le premier moyen de fermeture à une position fermée lorsque le moyen de verrouillage d'accès occupe une position fermée et pour permettre au premier moyen de fermeture de s'ouvrir lorsque le moyen de verrouillage d'accès occupe une position ouverte;

un moyen de tirage (617) accouplé au premier contenant pour amener le moyen de verrouillage d'accès de sa position ouverte à sa position fermée, le moyen de tirage étant agencé pour ne pas amener le moyen de verrouillage d'accès indépendamment de la position fermée à la position ouverte du moyen de verrouillage d'accès; et

un pied de verrouillage (605) accouplé au second contenant pour faire coopérer le moyen de verrouillage d'accès et le moyen de tirage de manière que le moyen de tirage et le pied de verrouillage puissent amener le moyen de verrouillage d'accès de sa position fermée à sa position ouverte.

9. Jonction selon la revendication 8, caractérisée en ce que le moyen de verrouillage d'accès comprend en outre un premier ressort (626) pour maintenir le moyen de verrouillage d'accès à la position fermée lorsque les premier et second contenants ne sont pas disposés à complémentarité de formes dans le moyen d'alignement, indépendamment de la position du moyen de tirage.

10. Jonction selon la revendication 8 ou 9, caractérisée en ce que pied de verrouillage (605) est conçu en plus pour maintenir le second moyen de fermeture (60) à une position fermée lorsque le pied de verrouillage occupe une position fermée et pour permettre au second moyen de fermeture de s'ouvrir lorsque le pied de verrouillage occupe une position ouverte.

11. Jonction selon la revendication 10, caractérisée en ce que le pied de verrouillage comprend en plus un deuxième ressort (603) pour maintenir le pied de verrouillage (605) à la position fermée lorsque les premier et second contenants ne sont pas disposés à complémentarité de formes dans le moyen d'alignement.

12. Jonction selon l'une quelconque des revendications 8 à 11, caractérisée en ce que le pied de verrouillage (605) est conçu en plus pour s'engager dans le moyen d'alignement (95) lorsque le moyen de verrouillage d'accès (613) est amené de la position fermée à la position ouverte par l'action conjointe du pied de verrouillage et du moyen de tirage (617), de manière que les premier et second contenants ne puissent pas être séparés lorsque le moyen de verrouillage d'accès occupe la position ouverte.

13. Jonction selon l'une quelconque des revendications 8 à 12, caractérisée en ce que le moyen de tirage (617) comporte en outre un moyen de déplacement (615, 619) pour déplacer le moyen de tirage entre une première et une seconde position correspondant respectivement à la position fermée et à la position ouverte du moyen de verrouillage d'accès (613).

14. Jonction selon la revendication 13, caractérisée en ce que le moyen de déplacement est constitué par un vérin pneumatique (615) à double effet.

15. Jonction selon la revendication 13 ou 14, caractérisée en ce que moyen de déplacement est constitué par un vérin pneumatique comportant un troisième ressort pour maintenir le moyen de tirage (617) à la première position (position fermée) lorsque le vérin pneumatique n'est pas actionné.

FIG 1

EP 0 151 336 B1

Fig.2B.

80

82

85

100

Fig.2A.

70

90

20

97 95 50

82

85

80

60 100

110

30

CASSETTE
GRIPPER
130

ARM
120

MOUNTING
PLATE
170

DAMPER
181

DAMPER
181

THUMB
WHEEL
160

BEARING
150

DAMPER
181

GRIPPER
SWITCH
155

HAND
GRIP
140

DOOR
CLOSED

OPEN

PORT
SWITCH
180

CASSETTE
80

INSIDE    OUTSIDE

FIG 3A

EP 0 151 336 B1

POKER 182

FIG 3B

EP 0 151 336 B1

# WAFER GRIPPER 183

FIG 3C

FIG 4A

FIG 5

6

Fig.4B.

Fig.6.

EP 0 151 336 B1

Fig.7A.

605

Fig 7B.

605

Fig.7C.

605

Fig.8A.

603

Fig.8C.

603

Fig.8B.

603

*Fig.9B.*

603

605

*Fig.9A.*

603

605

*Fig.10A.*

609

*Fig.10C.*

609

*Fig.10B.* 609

*Fig.11.*

615

Fig.12A.

Fig.12C.

618

618

Fig.12B.

618

Fig.13A.

95

Fig.13C.

95

Fig.13B.

95

Fig.14A.

617

Fig.14C.

617

Fig.14B.

617

Fig.15A.

613

Fig.15C.

613

Fig.15B.

613

12

FIG 16

FIG 17

FIG 18